# EUROPÄISCHE PATENTSCHRIFT

(11) **EP 3 490 351 B1**
(45) Veröffentlichungstag und Bekanntmachung des Hinweises auf die Patenterteilung: **11.11.2020**
(21) Anmeldenummer: 17203565.1
(22) Anmeldetag: 24.11.2017
(51) Int. Cl.: H05K 7/20

(54) **NIEDERSPANNUNGSSCHALTGERÄT MIT EINER DEFINIERTEN KÜHLANORDNUNG**
LOW VOLTAGE SWITCHING DEVICE WITH A DEFINED COOLING ARRANGEMENT
APPAREIL DE COMMUTATION BASSE TENSION DOTÉ D'UN DISPOSITIF DE REFROIDISSEMENT DÉFINI

(43) Veröffentlichungstag der Anmeldung: 29.05.2019
(73) Patentinhaber: Siemens Aktiengesellschaft, 80333 München (DE)
(72) Erfinder: Reichenbach, Norbert, 92224 Amberg (DE); Käsbauer, Peter, 92421 Schwandorf (DE)

(56) Entgegenhaltungen:
- EP-A1- 1 733 600
- EP-A2- 0 356 991
- EP-A2- 1 947 920

## Beschreibung

Die Erfindung betrifft ein Niederspannungsschaltgerät mit einem Gerätenennstrombereich bis 650 A aufweisend eine definierte Kühlanordnung mit einem Aufbau, welcher einen unteren und einen oberen Gerätebereich aufweist, wobei im unteren Gerätebereich leistungselektronische Bauelemente angeordnet sind.

In mehrphasigen Stromnetzen, in der überwiegenden Zahl sind diese dreiphasig, werden leistungselektronische Geräte, wie z.B. Sanftstarter, zur Steuerung des Energieflusses eingesetzt. In jeder Netzphase befinden sich hierzu leistungselektronische Bauelemente, auch Leistungsteile genannt, die den Stromfluss geeignet beeinflussen. Bei Sanftstartern besteht ein Leistungsteil aus zwei leistungselektronischen Bauelementen, dies sind Thyristoren in Antiparallelschaltung, welche mit Kühlmitteln wie Kühlkörpern versehen sind. Die Kühlmittel werden benötigt, um die Verlustwärme, die durch die Stromsteuerung in den leistungselektronischen Bauelementen entsteht, von diesen wegzuführen und damit unzulässige Temperaturen in diesen zu vermeiden.

Ein weiteres Kühlmittel sind Lüfter zur Verbesserung der Wärmeabfuhr von den Kühlkörpern. Diese ermöglichen einen höheren Gerätenennstrom oder auch höhere Schaltspielzahlen. Häufig werden den Leistungsteilen mechanische Bypass-Schaltelemente parallelgeschaltet, die in den Betriebsphasen, in welchen keine Stromsteuerung erforderlich ist, die Leistungsteile überbrücken, so dass in ihnen keine elektrische Verlustleistung mehr entsteht. Für die Ansteuerung der Leistungsteile und eventuell vorhandener Bypass-Schaltelemente sowie für die elektrische Versorgung eines Lüfters oder auch mehrerer, benötigt der Sanftstarter ein Steuerteil. Dieses übernimmt außerdem die Versorgung der Bedieneinheit des Gerätes sowie die Versorgung der Kommunikationsbaugruppe wie z.B. einer Profibus-Schnittstelle.

Die Bedieneinheit sowie die Kommunikationsbaugruppe können ein fester Teil des Steuerteils sein, aber auch als steckbare Einheiten in das Steuerteil integriert werden.

Weiterhin müssen Melderelais angesteuert werden, welche bestimmte Betriebszustände an externe Steuerungen weitermelden. Um diese Aufgaben erfüllen zu können, verfügt das Steuerteil über ein leistungsfähiges Netzteil zur Versorgung dieser Funktionsgruppen sowie über einen oder mehrere Mikroprozessoren, welche das Zusammenspiel der Funktionsgruppen organisieren.

Verglichen mit früheren Sanftstartern hat der Funktionsumfang des Steuerteils deutlich zugenommen und damit auch die in ihm umgesetzte elektrische Verlustleistung, welche sich um einen Faktor von ca. 2 - 2,5 erhöht hat. Zusätzlich zur dadurch verursachten Eigenerwärmung erfährt das Steuerteil und dessen integrierte Funktionsgruppen eine weitere Erwärmung durch die Leistungsteile sowie die Stromwärmeverluste in den Bypass-Schaltelementen und inneren Verbindungsleitungen. Es stellt sich damit die Aufgabe, das Steuerteil und dessen integrierte Funktionsgruppen so zu kühlen, dass beim Gerätebetrieb keine unzulässig hohen Temperaturen an den Bauteilen des Steuerteils und der integrierten Funktionsgruppen entstehen.

Aus dem Stand der Technik sind Steuerteile mit einem deutlich geringeren integrierten Funktionsumfang bekannt und einer geringeren Verlustleistung. Daher wurden die Bypass-Schaltelemente und die Lüfter direkt von der Spannungsversorgung versorgt, an die auch das Steuerteil angeschlossen war. Ebenfalls war der räumliche Abstand zwischen Steuerteil und den Leistungsteilen größer infolge des tieferen Gehäuses, so dass deren Wärmeeintrag in das Steuerteil gering war. Maßnahmen zur Unterstützung der natürlichen Konvektion wie Gitteröffnungen im Steuerteilgehäuse waren bisher ausreichend, um die Bauteiltemperaturen in einem zulässigen Bereich zu halten.

Aus dem Stand der Technik ist es auch bekannt, ein oder mehrere separate Lüfter für das Steuerteil zu verwenden oder ein konstruktiv größeres Steuerteil mit einer größeren Gehäuseoberfläche zu wählen, damit die Verlustleistung besser verteilt und mit natürlicher Konvektion abgeführt werden kann. Eine weitere konstruktive Möglichkeit besteht darin, die Geräte mit einem größeren Bauraum auszustatten, um den Abstand zwischen Steuerteil und wärmeerzeugenden Leistungsteilen zu vergrößern und den durch diese verursachten Wärmeeintrag zu verringern.

Die EP 1 733 600 A1 beschreibt ein Motorsteuergerät aufweisend einen Aufbau, welcher einen unteren und einen oberen Gerätebereich aufweist, wobei im oberen Gerätebereich leistungselektronische Bauelemente angeordnet sind, wobei im Gerät eine Kühleinheit zur Aufnahme von Kühlkörpern angeordnet ist. Darüber hinaus sind Lüfter zur aktiven Kühlung des Motorsteuergeräts vorgesehen.

Aus der EP 0 356 991 A2 geht eine Wechselrichtervorrichtung hervor mit einem Hauptschaltungsabschnitt mit einem wärmeerzeugenden Element; einem Logikabschnitt, welcher getrennt vom Hauptschaltungsabschnitt angeordnet ist; einem Abschirmglied, welches zwischen Hauptschaltungsabschnitt und Logikabschnitt angeordnet ist; und einem Kühlmittel, welches den Hauptschaltungsabschnitt kühlt, wobei der Hauptschaltungsabschnitt und der Logikabschnitt so ausgebildet sind, dass sie durch das Abschirmglied in unabhängigen Kammern angeordnet sind. Zudem umfasst die Wechselrichtervorrichtung ein erstes Gehäuse, welches den Hauptschaltungsabschnitt von der Außenseite trennt, und ein zweites Gehäuse, welches den Logikabschnitt von der Außenseite trennt. Das Abschirmglied ist zwischen dem ersten und zweiten Gehäuse angeordnet und weist ein Wärmeisoliermaterial und ein am Logikabschnitt angeordnetes elektromagnetisches Abschirmglied auf. Das Wärmeisoliermaterial und das elektromagnetische Abschirmglied bilden einen Kühlmediumkanal aus.

Die EP 1 947 920 A2 beschreibt eine Kühlanordnung für in einem Gehäuse angeordnete elektrische Komponenten eines Sanftanlaufgerätes, welches insbesondere zum Betreiben eines Elektromotors ausgebildet ist. Die Kühlanordnung weist mindestens ein Gebläse auf, welches in einer Öffnung einer Gehäusewand schräg eingebaut ist, so dass die Drehachse α des Gebläses zur senkrechten (S) der Gehäusewand geneigt ist.

Die Nachteile der aus dem Stand der Technik bekannten Lösungen bestehen darin, dass sie kostenintensiv und konstruktiv ungünstig sind.

Demgemäß besteht die Aufgabe der vorliegenden Erfindung darin, ein Niederspannungsschaltgerät, insbesondere einen Sanftstarter zu schaffen, mit einer definierten und platzoptimierten Kühlanordnung.

Diese Aufgabe wird erfindungsgemäß durch ein Niederspannungsschaltgerät mit den Merkmalen des Patentanspruchs 1 gelöst. Vorteilhafte Aus- und Weiterbildungen, welche einzeln oder in Kombination miteinander eingesetzt werden können, sind der Gegenstand der abhängigen Ansprüche.

Erfindungsgemäß wird diese Aufgabe durch ein Niederspannungsschaltgerät mit einem Gerätenennstrombereich bis 650 A gelöst aufweisend eine definierte Kühlanordnung mit einem Aufbau, welcher einen unteren und einen oberen Gerätebereich aufweist, wobei im unteren Gerätebereich leistungselektronische Bauelemente angeordnet sind. Die Erfindung zeichnet sich dadurch aus, dass im Niederspannungsschaltgerät nur ein Kühlmittel angeordnet ist und ein zweites Kühlmittel durch definierte Luftstromkanäle ersetzt ist.

Das Niederspannungsschaltgerät, insbesondere ein Sanftstarter, weist einen unteren Gehäusebereich auf mit einem Kühlmittel und vorzugsweise drei leistungselektronischen Bauelementen. Das Kühlmittel bläst die kühle Luft in den unteren Gehäusebereich. Die Hauptströmung der eintretenden Luft geht durch die Leistungsteile hindurch.

Ein weiterer Teil der in das Gehäuse eintretenden kühlen Luft trifft auf Luftleitwände und wird in Kammern geleitet, noch bevor sie sich nennenswert erwärmen kann. Von dort wird die Luft nach oben geleitet und tritt durch Öffnungen im Oberteil in den oberen Gehäusebereich ein.

Ein weiterer zusätzlicher Teil der Luft trifft auf einen weiteren Satz an Luftleitwände und wird ebenfalls nach oben geleitet in einen Bereich oberhalb des Lüfters und gelangt von dort ebenfalls durch Öffnungen in den oberen Gehäusebereich nach oben. Somit entsteht im oberen Gehäusebereich eine Nebenströmung, die das Steuerteil kühlt. Damit diese Nebenströmung sich möglichst wenig mit der heißen Luft der Hauptströmung vermischen kann, hat der obere Gehäusebereich einen weitgehend geschlossenen Boden, welcher als Trennwand zwischen Haupt- und Nebenströmung dient. Das Abzweigen eines Teils der eintretenden kühlen Luft unmittelbar hinter dem Kühlmittel, noch bevor sie sich nennenswert erwärmen kann sowie die konstruktive Trennung der heißen Hauptströmung (Leistungsteilkühlung) von der kalten Nebenströmung (Steuerteilkühlung) sind die wesentlichen Punkte bei der Lösung des vorliegenden Problems.

In der hier dargestellten Lösung besteht der obere Gehäusebereich aus einem mittleren Gehäuseteil und einem oberen Gehäuseteil, wobei das obere Gehäuseteil vorzugsweise auf das mittlere Gehäuseteil aufgeschraubt ist.

Das obere Gehäuseteil enthält eine Aussparung für die Aufnahme des Steuerteils sowie eine Aussparung für das ins Steuerteil integrierte oder separate Kommunikationsmodul. Die in das mittlere Gehäuseteil eintretende Luft tritt nun an verschiedenen Stellen im oberen Gehäuseteil hindurch und kühlt damit die Steuerplatine, insbesondere eine RC-Beschaltungsflachbaugruppe, die Unterseite der im Steuerteil enthaltenen Flachbaugruppe, das in der Aussparung sitzende Kommunikationsmodul sowie die im Steuerteil in der Aussparung sitzende, herausnehmbare Bedieneinheit. Die erwärmte Luft verlässt dann das Gerät über die an der Oberseite des Gehäuseoberteils angebrachten Gitteröffnungen. Damit möglichst viel von der im mittleren Gehäuseteil eintretenden Luft das Steuerteil und seine Funktionsgruppen kühlend durchströmt und anschließend nach oben austritt, haben das mittlere Gehäuseteil und das obere Gehäuseteil nur an der Oberseite Gitteröffnungen. Öffnungen an den anderen drei Seiten (unten, seitlich) sind auf das Notwendigste beschränkt.

Der wesentliche Vorteil der hier vorgestellten Lösung besteht darin, dass kein zusätzliches Kühlmittel wie z.B. ein Lüfter, für die Kühlung des Steuerteils benötigt wird bzw. eingespart wird. Ein zusätzliches Kühlmittel wie z.B. ein Lüfter, würde zusätzlichen Platz im Steuerteil benötigen und müsste auch so angeordnet sein, dass sein Luftstrom alle zu kühlenden Funktionsbaugruppen erreicht. Bei einem komplexen Gebilde wie dem hier gezeigten Steuerteil ist dies nicht einfach umzusetzen und erfordert einigen konstruktiven Aufwand, so dass das Steuerteil dann nicht mehr so kompakt gebaut werden kann. Ist das zusätzliche Kühlmittel ein Lüfter, müsste er außerdem überwacht werden und austauschbar sein. Im Gegensatz hierzu wird bei der hier vorgestellten Lösung ein verteilter Kühlluftstrom erzeugt, der alle Funktionsgruppen des Steuerteils ausreichend durchströmt.

Es müsste außerdem eine Eintrittsöffnung für die kühle Luft vorhanden sein, die bevorzugt an der Oberseite des Steuerteils angebracht sein müsste, da nur dort kühle Umgebungsluft verfügbar ist. Dort sind aber die Bedieneinheit bzw. Bedienelemente oder gerätebeschreibende Beschriftungen angebracht. Somit bedingt auch dies konstruktive Aufwände im Steuerteil, die das Steuerteil größer und komplexer machen. Die zusätzliche Integration eines zusätzlichen Kühlmittels, wie z.B. eines Lüfters, in das Steuerteil kann auch dazu führen, dass das Gerätegehäuse, welches das Steuerteil aufnimmt, angepasst werden muss und damit auch das Gehäusekonzept der Produktreihe modifiziert werden muss. Der konstruktive Aufwand für die Integration eines Steuerteilkühlmittels, wie z.B. eines Lüfters, kann erheblich sein und sogar das Gehäusekonzept der Produktreihe insgesamt beeinflussen. Dieser Aufwand entfällt ebenfalls bei der dargestellten Lösung.

Weiterhin muss das Steuerteil die zusätzliche elektrische Leistung für das Steuerteilkühlmittel wie z.B. einen Lüfter, aufbringen und etwas größer dimensioniert werden. Auch dieser Aufwand entfällt bei der vorliegenden Lösung.

In einer besonders vorteilhaften Ausgestaltung der Erfindung kann es vorgesehen sein, dass die Kühlmittel, wie z.B. Lüfter, im unteren Gerätebereich einen Teil des Luftstroms in Form von Teilluftströmen zu den benachbarten leistungselektronischen Bauelementen führt.

Eine erfindungsgemäße Weiterführung dieses Konzepts kann darin bestehen, dass ein Teil des Luftstroms auf Luftleitwände führbar ist, welche von sich gegenüberliegenden Seitenwänden nach innen in das Gehäuse des Niederspannungsschaltgeräts ragen und Kammern ausbilden, in welchen Luftstromkanäle angeordnet sind, welche den Luftstrom nach oben zum mittleren Gerätebereich führen.

In einer weiteren speziellen Fortführung des erfindungsgemäßen Konzepts kann es vorgesehen sein, dass ein Teil des Luftstroms auf Luftleitwände führbar ist, welche zentral vor dem Lüfter im Niederspannungsschaltgerät positioniert sind und den Luftstrom über Luftkanäle nach oben in einen Bereich zum oberen Gerätebereich führen.

Eine erfindungsgemäße Weiterführung dieses Konzepts kann vorsehen, dass die nach oben in den oberen Gerätebereich geführten Luftströme einen Nebenstrom ausbilden, welcher sich durch einen weitgehend geschlossenen Zwischenboden zwischen dem unteren und dem oberen Gerätebereich ausbildet.

In einer besonders vorteilhaften Ausgestaltung der Erfindung kann es vorgesehen sein, dass Luftströme über Gitteröffnungen im Gehäuse des Niederspannungsschaltgeräts nach außen zu führen sind.

Eine erfindungsgemäße Weiterführung dieses Konzepts kann darin bestehen, dass ein Kommunikationsmodul im Steuerteil integriert oder separat positioniert im Niederspannungsschaltgerät angeordnet ist.

In einer weiteren speziellen Fortführung des erfindungsgemäßen Konzepts kann es vorgesehen sein, dass das Niederspannungsschaltgerät ein Sanftstarter ist.

Das erfindungsgemäße Niederspannungsschaltgerät weist vorzugsweise ein quaderförmiges Gehäuse auf mit einer Gehäuseunterseite, auf welcher vier Seitenwände in einem Winkel von ca. 90° zueinander angeordnet sind und welche von einer Gehäuseoberseite abgeschlossen werden. Das Niederspannungsschaltgerät kann innerhalb des Gehäuses in zwei Gerätebereiche unterteilt sein, insbesondere einem unteren und einem oberen Bereich. Der obere Gerätebereich kann aus konstruktiven und funktionalen Gründen ein- oder mehrteilig ausgeführt sein, in der hier vorgestellten Lösung ist er zweiteilig ausgeführt als mittleres und oberes Gehäuseteil. Vorzugsweise im unteren Gerätebereich können Kühlmittel, wie z.B. ein oder mehrere Lüfter, angeordnet sein, welche innerhalb einer Seitenwand positioniert sind. Innenseitig ist der Bereich nach dem Kühlmittel im Gehäuse in vorzugsweise drei Kammern aufgeteilt. Diese Aufteilung ist vorzugsweise durch eingezogene Teilungswände im Gehäuseinneren umgesetzt. Die sich dadurch bildenden Kammern sind zwischen zwei sich gegenüberliegenden Seitenwänden des Gehäuses ausgebildet und zwar derart, dass darin positionierte leistungselektronische Bauelemente parallel zueinander und in Längsrichtung zur Strömungsrichtung der Luftkanäle, welche durch das Kühlmittel mit kühlender Luft versorgt werden, ausgerichtet sind. Die leistungselektronischen Bauelemente sind vorzugsweise quaderförmig ausgebildet mit vier Seitenwänden, einer Oberseite sowie einer Unterseite.

Die mittlere Kammer ist direkt nach dem Kühlmittel, also zentral, in Luftströmungsrichtung positioniert. Die anderen beiden Kammern sind jeweils an den sich gegenüberliegenden äußeren Seitenwänden des Gehäuses des Niederspannungsschaltgeräts angeordnet. Im Anschluss an das Kühlmittel sind jeweils als Bestandteil für die nachgeordneten Kammern Teilwände in Form von Luftleitwänden für die Luftdurchströmung angeordnet. Bei der mittleren Kammer sind dafür vorzugsweise zwei sich gegenüberliegende Luftleitwände ausgebildet. Für die äußeren Kammern wurden vorzugsweise jeweils Luftleitwände, welche von den jeweiligen Seitenwänden des Gehäuses nach innen gezogen ausgebildet sind, positioniert.

Die parallel ausgebildeten Teilungswände der mittleren Kammer sind vorzugsweise nach den Luftleitwänden in Luftströmungsrichtung versetzt ausgebildet, derart, dass sie zwar weiterhin parallel zu den Seitenwänden des Gehäuses verlaufen, aber unter Beibehaltung des Abstands zueinander näher zu einer der beiden Seitenwänden ausgerichtet sind. Diese Teilungswände der mittleren Kammer sind an der gegenüberliegenden Seite zu den Luftleitwänden aufeinander zugerichtet ausgebildet, vorzugsweise mit einem Winkel von ca. 10 bis 20°.

Die Teilwände der äußeren Kammern definieren jeweils seitlich neben dem zentral positionierten Lüfter Luftschächte, welche durch vorzugsweise parallel zueinander ausgerichtete nach innen gerichtete Teilwände an der Seitenwand, in welcher das Kühlmittel integriert ist, weiter unterteilt werden und definierte Luftkanäle ausbilden.

Weitere Strömungshindernisse sind im Lufteintrittsbereich des mittleren Luftkanals am Boden, seitlich und oberhalb der leistungselektronischen Bauelemente angebracht. Diese Strömungskanalanpassungen bewirken die geringere Durchströmung des mittleren Kanals, der strömungstechnisch am günstigsten liegt.

Unterschiedlich große Öffnungen stellen eine in etwa gleiche Durchströmung bzw. Kühlwirkung für die beiden äußeren Leistungsteile sicher. Deshalb ist der Luftdurchtritt im Mittelbereich kleiner als der Luftdurchtritt im äußeren Randbereich.

Weitere Vorteile und Ausführungen der Erfindung werden nachfolgend anhand eines Ausführungsbeispiels sowie anhand der Zeichnung näher erläutert.

Dabei zeigen:
- Fig. 1: in einer perspektivischen Darstellung ein unterer Gerätebereich eines Niederspannungsschaltgeräts mit einem Kühlmittel, welches hier beispielhaft als Lüfter ausgebildet ist, und einer definierten Ausbildung der Luftdurchströmungskanäle für nachgeschaltete leistungselektronische Bauelemente;
- Fig. 2: in einer perspektivischen Darstellung ein Ausschnitt des unteren Gerätebereichs mit Lüfter aus Fig. 1 und definierten Luftstromkanälen;
- Fig. 3: in einer perspektivischen Darstellung ein mittleres Gehäuseteil mit definierten Luftstromkanälen, welche eine Fortsetzung der Luftstromkanäle aus dem unteren Gerätebereich bilden;
- Fig. 4: in einer Draufsicht die Darstellung nach Fig. 3 ohne Beschaltungsplatine;
- Fig. 5: in einer perspektivischen Darstellung ein oberes Gehäuseteil mit definierten Luftstromkanälen, welche eine Fortsetzung der Luftstromkanäle aus dem mittleren Gehäuseteil bilden;
- Fig. 6: in einer perspektivischen Darstellung das erfindungsgemäße Niederspannungsschaltgerät mit Gehäuse;
- Fig. 7: in einer perspektivischen Darstellung das Niederspannungsschaltgerät nach Fig. 6 mit Gitteröffnungen im Gehäuse zur Abgabe der Luftströme nach außen.

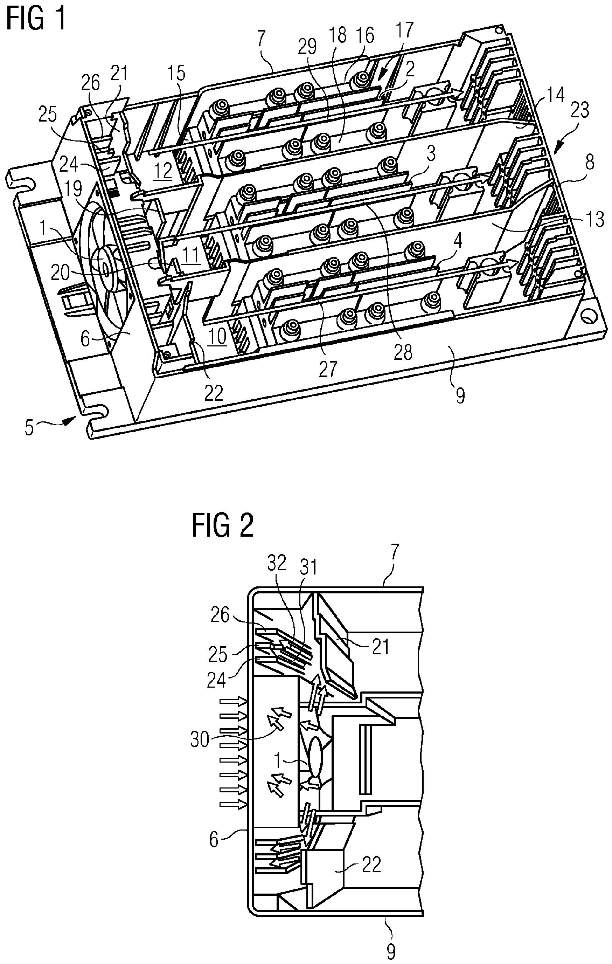

Fig. 1 zeigt einen erfindungsgemäßen unteren Gerätebereich eines Niederspannungsschaltgeräts mit einem Kühlmittel 1, welches hier als ein einziger Lüfter ausgebildet ist, und einer definierten Ausbildung der Luftdurchströmungskanäle für nachgeschaltete leistungselektronische Bauelemente 2, 3, 4.

Das erfindungsgemäße Niederspannungsschaltgerät weist vorzugsweise ein quaderförmiges Gehäuseunterteil auf mit einer Gehäuseunterseite, auf welcher vier Seitenwände 6, 7, 8, 9 in einem Winkel von ca. 90° zueinander angeordnet sind und welche von einer Gehäuseoberseite abgeschlossen werden. Das Niederspannungsschaltgerät kann innerhalb des Gehäuses 5 in zwei Gehäusebereiche unterteilt sein, in einen unteren und einen oberen Bereich. Der obere Gehäusebereich kann aus konstruktiven und funktionalen Gründen ein oder auch mehrteilig ausgeführt sein, in der hier vorgestellten Lösung besteht der obere Gehäusebereich aus einem mittleren und einem oberen Gehäuseteil.

Vorzugsweise im unteren Gerätebereich ist ein Lüfter (1) angeordnet, welcher innerhalb der Seitenwand 6 positioniert ist. Innenseitig ist der Bereich nach dem Lüfter im Gehäuseunterteil in vorzugsweise drei Kammern 10, 11, 12 aufgeteilt. Diese Aufteilung ist durch eingezogene Teilungswände 13, 14 im Gehäuseinneren umgesetzt. Die sich dadurch bildenden Kammern 10, 11, 12 sind zwischen zwei sich gegenüberliegenden Seitenwänden 7, 9 des Gehäuseunterteils ausgebildet und zwar derart, dass darin positionierte leistungselektronische Bauelemente 2, 3, 4 parallel zueinander und in Längsrichtung zur Strömungsrichtung der Luftkanäle, welche durch den Lüfter mit kühlender Luft versorgt werden, ausgerichtet sind. Die leistungselektronischen Bauelemente 2, 3, 4 sind vorzugsweise quaderförmig ausgebildet mit vier Seitenwänden 15, 16, 17, 18 einer Oberseite sowie einer Unterseite.

Die mittlere Kammer 11 ist direkt nach dem Lüfter, also zentral, in Luftströmungsrichtung positioniert. Die anderen beiden Kammern 10, 12 sind jeweils an den sich gegenüberliegenden äußeren Seitenwänden 7, 9 des Gehäuseunterteils des Niederspannungsschaltgeräts angeordnet. Im Anschluss an den Lüfter sind jeweils als Bestandteil für die nachgeordneten Kammern 10, 11, 12 Luftleitwände 19, 20, 21, 22 für die Luftdurchströmung angeordnet. Bei der mittleren Kammer 11 sind dafür vorzugsweise zwei sich gegenüberliegende Luftleitwände 19, 20 ausgebildet. Für die äußeren Kammern 10, 12 wurde vorzugsweise jeweils eine Luftleitwand 21, 22, welche von den jeweiligen Seitenwänden 7, 9 des Gehäuses nach innen gezogen sind, positioniert.

Die parallel ausgebildeten Teilungswände 13, 14 der mittleren Kammer 11 sind vorzugsweise nach den Luftleitwänden in Luftströmungsrichtung versetzt ausgebildet, derart, dass sie zwar weiterhin parallel zu den Seitenwänden 7, 9 des Gehäuseunterteils verlaufen, aber unter Beibehaltung des Abstands zueinander näher zu einer der beiden Seitenwänden 7, 9 ausgerichtet sind. Diese Teilungswände 13, 14 der mittleren Kammer 11 sind an der gegenüberliegenden Seite zu den Luftleitwänden aufeinander zugerichtet ausgebildet, vorzugsweise mit einem Winkel von ca. 10 bis 20°, so dass sich eine Verengung 23 ausbildet.

Die Teilwände Luftleitwände 21, 22 der äußeren Kammern 10, 12 definieren jeweils seitlich neben dem zentral positionierten Lüfter Kammern, welche durch vorzugsweise parallel zueinander ausgerichtete nach innen gerichtete Luftleitwände 24, 25, 26 an der Seitenwand 6, in welcher der Lüfter integriert ist, weiter unterteilt werden und definierte Luftkanäle ausbilden.

Weitere Strömungshindernisse sind im Lufteintrittsbereich dieses Luftkanals am Boden, seitlich und oberhalb der leistungselektronischen Bauelemente 2, 3, 4 angebracht. Diese Strömungskanalanpassungen bewirken die geringere Durchströmung des mittleren Kanals 11, der strömungstechnisch am günstigsten liegt.

Unterschiedlich große Öffnungen stellen eine in etwa gleiche Durchströmung bzw. Kühlwirkung für die beiden äußeren leistungselektronische Bauelemente 2, 4 sicher. Deshalb ist der Luftdurchtritt im Mittelbereich kleiner als der Luftdurchtritt im äußeren Randbereich.

Die in Pfeilrichtung dargestellten Teilluftströme 27, 28, 29 in den drei Kammern 10, 11, 12 sind hinsichtlich ihrer Intensität unterschiedlich ausgebildet.

In Fig. 2 ist ein Ausschnitt des unteren Gerätebereichs mit Lüfter und definierten Luftstromkanälen dargestellt. Der Lüfter ist in der Seitenwand 6 angeordnet. Seitlich neben dem Lüfter sind durch die Luftleitwände 21, 22 und die Seitenwände 6 bzw. 7, 9 kleine Kammern bzw. Luftschächte ausgebildet, welche vom Lüfter mit Luft durchströmt werden. Durch die Luftleitwände 24, 25, 26 wird die Luft in definierte Luftstromkanäle 31, 32 überführt. Ein Teil der vom Lüfter angezogenen Luft wird außerdem in einen Bereich 30 oberhalb des Lüfters geführt.

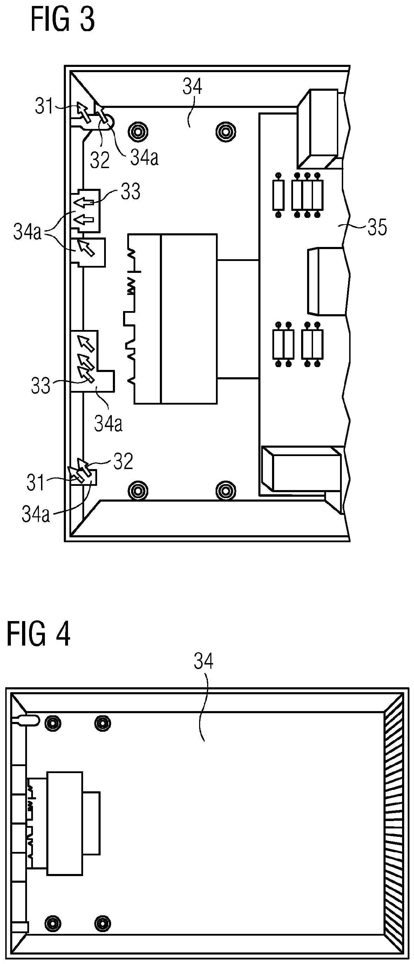

Fig. 3 zeigt ein mittleres Gehäuseteil mit fortgesetzten definierten Luftstromkanälen 31, 32 aus dem unteren Gerätebereich sowie mit fortgesetzten Luftstromkanälen 33 aus dem Bereich 30 des unteren Gerätebereichs. Das mittlere Gehäuseteil weist einen weitgehend geschlossenen Zwischenboden 34 mit Aussparungen 34a auf, auf welchem eine Platine 35, insbesondere eine RC-Beschaltungsplatine angeordnet ist.

Fig. 4 zeigt den mittleren Gerätebereich ohne Platine 35.

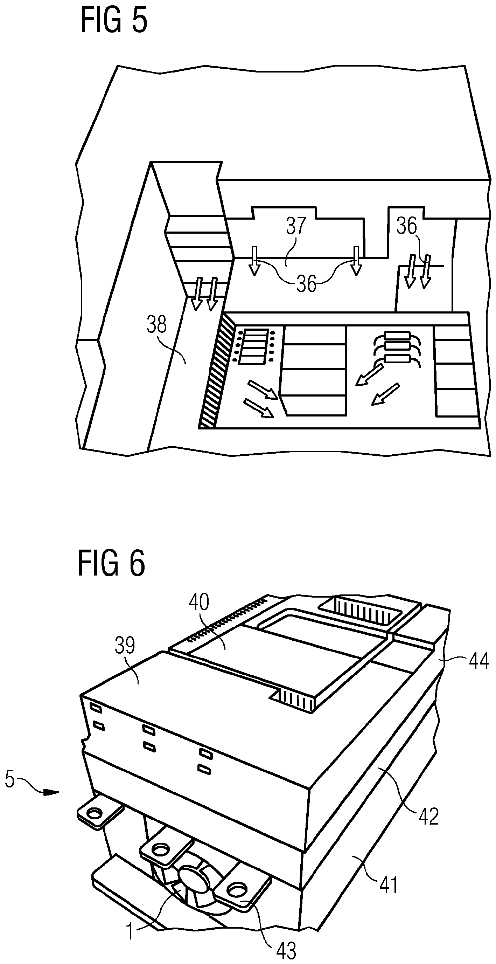

In Fig. 5 ist ein oberes Gehäuseteil mit definierten Luftstromkanälen 36 dargestellt, welche eine Fortsetzung der Luftstromkanäle 31, 32, 33 aus dem mittleren Gehäuseteil bilden. Das obere Gehäuseteil weist Aussparungen 37, 38 auf, in welche ein Steuerteil sowie ein Kommunikationsmodul positioniert werden können.

Fig. 6 zeigt das erfindungsgemäße Niederspannungsschaltgerät mit Gehäuse, wobei in Seitenwand 6 der Lüfter im unteren Gerätebereich angeordnet ist. In die Frontseite 39 ist das Steuerteil 40 eingesetzt. Zudem ist dieser Darstellung die Anordnung der drei Gehäuseteile 41, 42, 44 zu entnehmen. Im unteren Gehäuseteil 41 sind der Lüfter und die Anschlüsse 43 angeordnet. Im mittleren Gehäuseteil 42 ist die RC-Beschaltungsplatine angeordnet. Im oberen Gehäuseteil 44 wird das Steuerteil 40 eingesetzt.

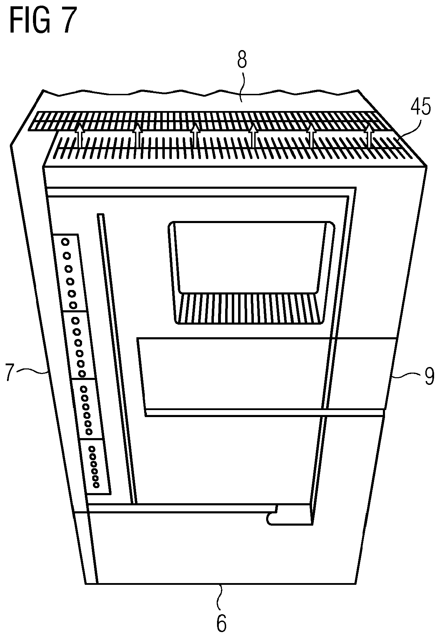

In Fig. 7 ist das Niederspannungsschaltgerät nach Fig. 6 mit Gitteröffnungen 45 in der Seitenwand 8 des Gehäuses zur Abgabe der Luftströme nach außen dargestellt.

Der erfindungsgemäße Niederspannungsschaltgerät zeichnet sich dadurch aus, dass auch bei Gerätenennströmen im Bereich bis 650 A eine zuverlässige Temperaturregulierung der leistungselektronischen Bauelemente realisierbar ist.

### Bezugszeichenliste

- 1: Kühlmittel
- 2: leistungselektronisches Bauelement
- 3: leistungselektronisches Bauelement
- 4: leistungselektronisches Bauelement
- 5: Gehäuse
- 6: Seitenwand
- 7: Seitenwand
- 8: Seitenwand
- 9: Seitenwand
- 10: Kammer
- 11: Kammer
- 12: Kammer
- 13: Teilungswand
- 14: Teilungswand
- 15: Seitenwand
- 16: Seitenwand
- 17: Seitenwand
- 18: Seitenwand
- 19: Luftleitwand
- 20: Luftleitwand
- 21: Luftleitwand
- 22: Luftleitwand
- 23: Verengung
- 24: Luftleitwand
- 25: Luftleitwand
- 26: Luftleitwand
- 27: Teilluftstrom
- 28: Teilluftstrom
- 29: Teilluftstrom
- 30: Bereich
- 31: Luftstromkanal
- 32: Luftstromkanal
- 33: Luftstromkanal
- 34: Zwischenboden
- 34a: Aussparung
- 35: Platine
- 36: Luftstromkanal
- 37: Aussparung
- 38: Aussparung
- 39: Frontseite
- 40: Steuerteil
- 41: unteres Gehäuseteil
- 42: mittleres Gehäuseteil
- 43: Anschluss
- 44: oberes Gehäuseteil
- 45: Gitteröffnung

## Patentansprüche

1. Niederspannungsschaltgerät mit einem Gerätenennstrombereich bis 650 A aufweisend eine definierte Kühlanordnung mit einem Aufbau, welcher einen unteren und einen oberen Gerätebereich aufweist, wobei im unteren Gerätebereich leistungselektonische Bauelemente (2, 3, 4) angeordnet sind, wobei im Niederspannungsschaltgerät ein Lüfter und definierte Luftstromkanäle (31, 32, 33, 36) angeordnet sind, wobei kühle Luft von dem Lüfter (1) in den unteren, die leistungselektronischen Bauelemente aufweisenden Gerätebereich geblasen werden kann,
**gekennzeichnet dadurch,**
**dass**
ein Teil der in das Gehäuse eintretenden kühlen Luft auf Luftleitwände (19,20,21,22) trifft und in Kammern geleitet wird, noch bevor sie sich nennenswert erwärmen kann, und von dort nach oben geleitet wird und durch Öffnungen im Oberteil in den oberen Gehäusebereich zur Kühlung des dort angeordneten Steuerteils eintritt.

2. Niederspannungsschaltgerät nach Anspruch 1, **dadurch gekennzeichnet, dass** der Lüfter (1) im unteren Gerätebereich einen Teil des Luftstroms in Form von Teilluftströmen (27, 28, 29) zu den benachbarten leistungselektronischen Bauelementen (2, 3, 4) führt.

3. Niederspannungsschaltgerät nach Anspruch 1 oder 2, **dadurch gekennzeichnet, dass** ein Teil des Luftstroms auf Luftleitwände (21, 22) führbar ist, welche von sich gegenüberliegenden Seitenwänden (7, 9) nach innen in das Gehäuse (5) des Niederspannungsschaltgeräts ragen und Kammern ausbilden, in welchen Luftstromkanäle (31, 32) angeordnet sind, welche den Luftstrom nach oben zum oberen Gerätebereich führen.

4. Niederspannungsschaltgerät nach einem der Ansprüche 1 bis 3, **dadurch gekennzeichnet, dass** ein Teil des Luftstroms auf Luftleitwände (19, 20) führbar ist, welche zentral vor dem Lüfter im Niederspannungsschaltgerät positioniert sind und den Luftstrom über Luftkanäle nach oben in einen Bereich (30) zum oberen Gerätebereich führen.

5. Niederspannungsschaltgerät nach Anspruch 3 oder/und 4, **dadurch gekennzeichnet, dass** die nach oben in den oberen Gerätebereich geführten Luftströme einen Nebenstrom ausbilden, welcher sich durch einen weitgehend geschlossenen Zwischenboden (34) zwischen dem unteren und dem oberen Gerätebereich ausbildet.

6. Niederspannungsschaltgerät nach Anspruche 5, **dadurch gekennzeichnet, dass** Luftströme über Gitteröffnungen (45) im Gehäuse (5) des Niederspannungsschaltgeräts nach außen zu führen sind.

7. Niederspannungsschaltgerät nach einem der Ansprüche 1 bis 6, **dadurch gekennzeichnet, dass** ein Kommunikationsmodul im Steuerteil integriert oder separat positioniert im Niederspannungsschaltgerät angeordnet ist.

8. Niederspannungsschaltgerät nach einem der Ansprüche 1 bis 7, **dadurch gekennzeichnet, dass** das Niederspannungsschaltgerät ein Sanftstarter ist.

## Claims

1. Low-voltage switching device with a device rated current range of up to 650 A, having a defined cooling arrangement with a structure which has a lower and an upper device region, wherein power-electronics components (2, 3, 4) are arranged in the lower device region, wherein a fan and defined airflow ducts (31, 32, 33, 36) are arranged in the low-voltage switching device, wherein cool air can be blown by the fan (1) into the lower device region which has the power-electronics components, **characterized in that** a portion of the cool air entering the housing strikes air-guiding walls (19, 20, 21, 22) and is conducted into chambers, even before it can heat up to any appreciable extent and, from there, the air is conducted upward and enters the upper housing region through openings in the top part for the purpose of cooling the control part arranged there.

2. Low-voltage switching device according to Claim 1, **characterized in that** the fan (1) in the lower device region guides a portion of the air flow in the form of partial air flows (27, 28, 29) to the adjacent power-electronics components (2, 3, 4).

3. Low-voltage switching device according to Claim 1 or 2, **characterized in that** a portion of the air flow can be guided on air-guiding walls (21, 22) which protrude from opposite side walls (7, 9) inward into the housing (5) of the low-voltage switching device and form chambers in which air flow ducts (31, 32) which guide the air flow upward to the upper device region are arranged.

4. Low-voltage switching device according to one of Claims 1 to 3, **characterized in that** a portion of the air flow can be guided on air-guiding walls (19, 20) which are positioned centrally in front of the fan in the low-voltage switching device and guide the air flow via air ducts upward into a region (30) to the upper device region.

5. Low-voltage switching device according to Claim 3 or/and 4, **characterized in that** the air flows which are guided upward into the upper device region form a secondary flow which forms through a largely closed intermediate floor (34) between the lower and the upper device region.

6. Low-voltage switching device according to Claim 5, **characterized in that** air flows are to be guided to the outside via grid openings (45) in the housing (5) of the low-voltage switching device.

7. Low-voltage switching device according to one of Claims 1 to 6, **characterized in that** a communications module is arranged in a manner integrated in the control part or separately positioned in the low-voltage switching device.

8. Low-voltage switching device according to one of Claims 1 to 7, **characterized in that** the low-voltage switching device is a soft starter.

## Revendications

1. Appareil de coupure de basse tension, ayant une plage de courant nominal d'appareil allant jusqu'à 650 A, comportant un système de refroidissement défini ayant une structure, qui a une partie d'appareil inférieure et une partie d'appareil supérieure, dans lequel, dans la partie d'appareil inférieure, sont disposés des composants (2, 3, 4) d'électronique de puissance, dans lequel, dans l'appareil de coupure de basse tension, sont disposés un ventilateur et des conduits (31, 32, 33, 36) définis de courant d'air, de l'air froid pouvant être insufflé du ventilateur (1) à la partie d'appareil inférieure ayant les composants d'électronique de puissance,
**caractérisé en ce que**
une partie de l'air froid entrant dans le boîtier arrive sur des parois (19, 20, 21, 22) d'acheminement de l'air et est envoyé dans des chambres encore avant de pouvoir s'échauffer d'une valeur notable et de là est envoyée vers le haut et entre par des ouvertures de la partie supérieure dans la partie supérieure du boîtier pour refroidir la partie de commande qui y est disposée.

2. Appareil de coupure de basse tension suivant la revendication 1, **caractérisé en ce que** le ventilateur (1), dans la partie inférieure de l'appareil, envoie une partie du courant d'air sous la forme de courants (27, 28, 29) partiels d'air aux composants (2, 3, 4) d'électronique de puissance voisins.

3. Appareil de coupure de basse tension suivant la revendication 1 ou 2, **caractérisé en ce qu'**une partie du courant d'air peut être conduite sur des parois (21, 22) d'acheminement de l'air, qui, à partir de parois (7, 9) latérales opposées, pénètrent à l'intérieur dans le boîtier (5) de l'appareil de coupure de basse tension et constituent des chambres, dans lesquelles sont disposés des conduits (31, 32) pour courant d'air, qui conduisent le courant d'air vers le haut à la partie supérieure de l'appareil.

4. Appareil de coupure de basse tension suivant l'une des revendications 1 à 3, **caractérisé en ce qu'**une partie du courant d'air peut être conduite sur des parois (19, 20) d'acheminement d'air, qui sont placées de manière centrale avant le ventilateur dans l'appareil de coupure de basse tension et qui conduisent le courant d'air par des conduits pour de l'air vers le haut dans une partie (30) vers la partie supérieure de l'appareil.

5. Appareil de coupure de basse tension suivant la revendication 3 ou/et 4, **caractérisé en ce que** les courants d'air conduits vers le haut dans la partie supérieure de l'appareil constituent un courant auxiliaire, qui se constitue par un fond (34) intermédiaire dans une grande mesure fermé entre la partie inférieure de l'appareil et la partie supérieure de l'appareil.

6. Appareil de coupure de basse tension suivant la revendication 5, **caractérisé en ce que** des courants d'air sont conduits vers l'extérieur par des ouvertures (45) de grille dans le boîtier (5) de l'appareil de coupure de basse tension.

7. Appareil de coupure de basse tension suivant l'une des revendications 1 à 6, **caractérisé en ce qu'**un module de communication est intégré dans la partie de commande ou est placé de manière séparée dans l'appareil de coupure de basse tension.

8. Appareil de coupure de basse tension suivant l'une des revendications 1 à 7, **caractérisé en ce que** l'appareil de coupure de basse tension est un démarreur doux.
